# EUROPEAN PATENT SPECIFICATION

(11) **EP 1 986 217 B1**
(45) Date of publication and mention of the grant of the patent: **24.04.2013**
(21) Application number: 07708227.9
(22) Date of filing: 08.02.2007
(51) Int. Cl.: H01L 21/02, C30B 31/22, C30B 33/06, H01L 21/20, H01L 21/265

(54) **METHOD FOR MANUFACTURING SEMICONDUCTOR SUBSTRATE**
VERFAHREN ZUM HERSTELLEN EINES HALBLEITERSUBSTRATS
PROCEDE DE FABRICATION D'UN SUBSTRAT SEMI-CONDUCTEUR

(30) Priority: 16.02.2006 JP 2006039504
(43) Date of publication of application: 29.10.2008
(73) Proprietor: Shin-Etsu Chemical Co., Ltd., Tokyo 100-0005 (JP)
(72) Inventor: AKIYAMA, Shoji, Annaka-shi, Gunma 379-0195 (JP); KUBOTA, Yoshihiro, Annaka-shi, Gunma 379-0195 (JP); ITO, Atsuo, Annaka-shi, Gunma 379-0195 (JP); KAWAI, Makoto, Annaka-shi, Gunma 379-0195 (JP); TOBISAKA, Yuuji, Annaka-shi, Gunma 379-0195 (JP); TANAKA, Koichi, Annaka-shi, Gunma 379-0195 (JP)
(74) Representative: HOFFMANN EITLE
(86) International application number: PCT/JP2007/052234
(87) International publication number: WO 2007/094231

(56) References cited:
- WO-A1-02/47156
- WO-A1-2005/096369
- WO-A2-02/43124
- WO-A2-03/062507
- FR-A1- 2 840 730
- JP-A- 2005 142 524

## Description

### Technical Field

The present invention relates to a method for manufacturing a semiconductor substrate in which a nitride-based semiconductor layer is formed on a substrate of a different type using a bonding technique.

### Background Art

Along with the miniaturization of semiconductor devices, requirements for high-voltage and high power density applications have become increasingly severe. Hence, there are growing expectations for a wide band gap semiconductor as a material capable of meeting such requirements. In particular, a nitride-based semiconducting material, as typified by a GaN-based semiconductor, is one of materials attracting the greatest attention partly because the material has led to such a remarkable achievement as the practical application of a blue-color light-emitting diode.

A nitride-based semiconductor crystal is superior in a variety of properties, including the saturated drift rate, dielectric breakdown voltage, thermal conductivity, and heterojunction characteristics, and is, therefore, being developed as a high-power, high-frequency electronic device. At present, the semiconductor crystal is being actively developed also as a high electron mobility transistor (HEMT) making use of a two-dimensional electron gas system.

The crystal growth of a nitride-based semiconductor is generally accomplished by an MOVPE method using organic metal as a raw material, an MBE method in which the crystal growth is achieved in ultrahigh vacuum, or an HVPE method using a halide as a raw material. For mass-production, however, an MOVPE method is most widely used. Both light-emitting diodes and semiconductor lasers, which are already in practical use, use nitride-based crystals grown by an MOPVE method.

However, since a costly single-crystal substrate, such as a sapphire substrate, a silicon carbide (SiC) substrate, or a zinc oxide (ZnO) substrate, is used for the MOVPE method-based growth of a nitride-based semiconductor crystal, a semiconductor substrate having the nitride-based semiconductor crystal on any of these substrates tends to be unavoidably expensive.

On the other hand, as a method for manufacturing a semiconductor substrate by bonding together two substrates, there is known the SmartCut method in which a silicon substrate, on the bonding surface side of which hydrogen ions have been implanted, and a handling substrate are bonded together and subjected to a heat treatment. Then, a silicon thin film is thermally peeled off from a region where the concentration of the implanted hydrogen ions is highest (see, for example, Japanese Patent No. 3048201 (patent document 1) and A. J. Auberton-Herve et al., "SMART CUT TECHNOLOGY: INDUSTRIAL STATUS of SOI WAFER PRODUCTION and NEW MATERIAL DEVELOPMENTS" (Electrochemical Society Proceedings Volume 99-3 (1999) pp. 93-106) (non-patent document 1))

However, since this method is based on a mechanism in which high-density "gas bubbles" formed by implanting hydrogen ions and called a "microbubble layer" are "grown" by heating, thereby peeling off a silicon thin film by taking advantage of this "bubble growth," the temperature of heat treatment for separation is unavoidably high. Accordingly, if the thermal expansion coefficients of the substrates to be bonded together differ significantly from each other, cracks or the like attributable to the thermal strain of the bonded substrate tend to occur. In addition, if either one of the substrates to be bonded together is a substrate in which elements have already been formed, there arises such a problem that the profile of a dopant changes due to a heat treatment at the time of separation and, therefore, element characteristics vary.

The present invention has been accomplished in view of the above-described problems. It is therefore an object of the present invention to provide a method for manufacturing a semiconductor substrate whereby it is possible to provide a nitride-based semiconductor device at low costs. Another object of the present invention is to provide a method for manufacturing a semiconductor substrate based on a low-temperature process, thereby preventing the occurrence of cracks and the like in substrates even when obtaining a nitride-based semiconductor substrate by bonding together substrates of different types, and thereby avoiding causing the characteristics of elements to vary even if a substrate in which the elements have already been formed is bonded.
WO 03/062507 A2 relates to a method for manufacturing a free-standing substrate made of monocrystalline semi-conductor material. The method comprises the steps of transferring of a thin nucleation layer onto a support by creating between the two a removable bonding interface and growing by epitaxy on said thin nucleation layer, a microcrystalline layer.
In FR 2 840 730 A1 a nucleation layer of silicon carbide is formed on a gallium arsenide intermediate support. A monocrystalline gallium nitride layer is grown on the nucleation layer and the gallium arsenide intermediate support is etched using an etching solution to form a monocrystalline semiconductor substrate.
WO 2005/096369 A1 concerns a method for preparing an oxidised surface of a wafer for bonding with another wafer.
WO 02/43124 A2 relates to method for making a substrate comprising a thin layer borne by a layer forming a mechanical support, in particular for optics, electronics or optoelectronics.
A process of gluing two wafers on two corresponding gluing surfaces is concerned in JP 2005-142524 A. This process comprises activating at least one gluing surface, and bringing the gluing surfaces into contact.
WO 02/47156 A1 concerns a method for producing a thin film from a structure, comprising the steps of producing a stacked structure, introducing gaseous species in the structure, and separating the thin film from the rest of the structure at a cleavage zone.

### Disclosure of the Invention

In order to solve the above-described problems, a method for manufacturing a semiconductor substrate according to the present invention includes:
a first step of forming a hydrogen ion-implanted layer on a surface side of a nitride-based semiconductor crystal epitaxially grown on a first substrate;
a second step of applying a surface activation treatment to at least one of a surface of a second substrate and the surface of the nitride-based semiconductor crystal;
a third step of bonding together the surface of the nitride-based semiconductor crystal and the surface of the second substrate; and
a fourth step of forming a nitride-based semiconductor layer on the second substrate by peeling off a nitride-based semiconductor crystal along the hydrogen ion-implanted layer, wherein
   said nitride-based semiconductor crystal is one of a GaN-based crystal, an AlN-based crystal and an InN-based crystal, and said hydrogen ion-implanted layer is formed in the low-dislocation density region of said nitride-based semiconductor crystal.

Preferably, the second step of surface activation treatment is carried out by means of at least one of plasma treatment and ozone treatment.

Still preferably, the third step includes a sub-step of heat-treating the nitride-based semiconductor crystal and the second substrate after the bonding together, with the semiconductor crystal and the substrate bonded together.

In a method for manufacturing a semiconductor substrate according to the present invention, the sub-step of heat treatment is preferably carried out at a temperature of 200°C or higher but not higher than 450°C.

In addition, in a method for manufacturing a semiconductor substrate according to the present invention, the fourth step can be carried out by applying mechanical shock from an edge of the hydrogen ion-implanted layer or by applying vibratory shock or thermal shock to the bonded substrate.

In these manufacturing methods, there may be included a fifth step of epitaxially growing a nitride-based semiconductor crystal on a nitride-based semiconductor layer staying on the first substrate after the peel-off, thereby providing a new substrate for bonding.

In addition, in these manufacturing methods, the nitride-based semiconductor crystal is a GaN-based, AlN-based or InN-based crystal, and the hydrogen ion-implanted layer is formed in the low-dislocation density region of the nitride-based semiconductor crystal.

In the present invention, a hydrogen ion-implanted layer is formed in a crystal of a nitride-based semiconductor provided on the first substrate and this nitride-based semiconductor crystal and the second substrate are bonded together to transfer the surface layer part of the low-dislocation density region of the nitride-based semiconductor crystal onto the second substrate, thereby eliminating the need for using a costly substrate for the growth of a nitride-based semiconductor crystal.

In addition, since the first substrate on which the lower layer part of the low-dislocation density region of the nitride-based semiconductor crystal stays can be reused as a substrate for epitaxial growth, it is possible to provide a semiconductor substrate whereby a nitride-based semiconductor device can be manufactured at low costs.

Furthermore, a method for manufacturing a semiconductor substrate according to the present invention does not involve applying a heat treatment at high temperatures, thereby preventing cracks or the like from occurring in a substrate, and thereby avoiding causing the characteristics of elements to vary even if a substrate in which the elements have already been formed is bonded.

### Brief Description of the Drawings

Figure 1 is a schematic view used to conceptually explain steps in a method for manufacturing a semiconductor substrate of the present invention;
Figure 2 is a schematic view used to explain a process example of a method for manufacturing a semiconductor substrate of the present invention; and
Figure 3 is a conceptual schematic view used to exemplify various techniques for peeling off a nitride-based semiconductor thin film, wherein Figure (A) illustrates an example of performing separation by thermal shock, Figure (B) illustrates an example of performing separation by mechanical shock, and Figure (C) illustrates an example of performing separation by vibratory shock.

### Best Mode for Carrying Out the Invention

Hereinafter, the best mode for carrying out the present invention will be described with reference to the accompanying drawings.

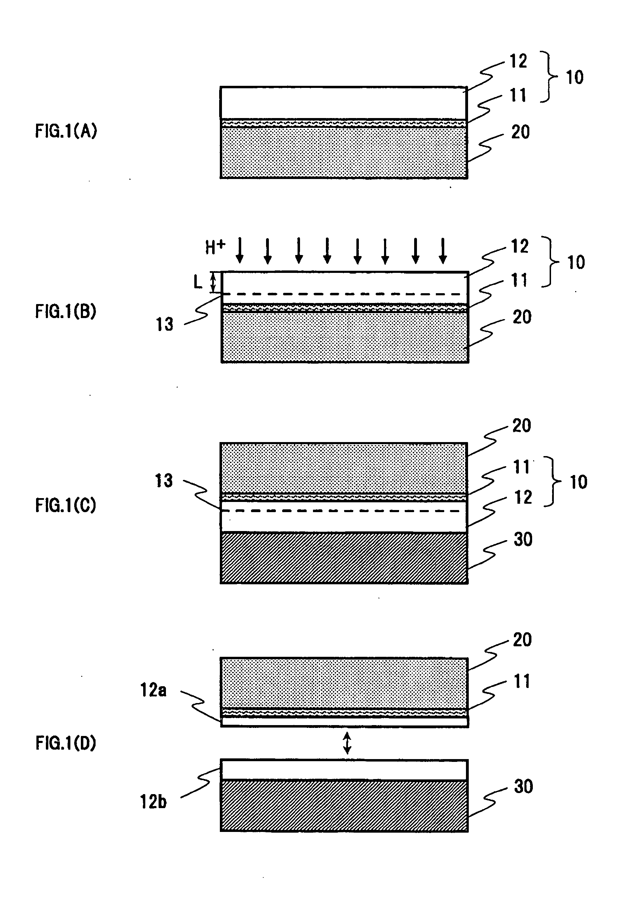

Figure 1 is a schematic view used to conceptually explain steps in a method for manufacturing a semiconductor substrate of the present invention. In this figure, reference numeral 10 denotes a film of a nitride-based semiconductor which has been epitaxially grown on a first substrate shown by reference numeral 20 using an MOVPE method. Note that the first substrate 20 is a sapphire substrate, a silicon carbide (SiC) substrate, a zinc oxide (ZnO) substrate or the like, and is of a type different in crystal structure and composition from the nitride-based semiconductor crystal 10.

As illustrated in Figure 1(A), the GaN-based, AlN-based or InN-based nitride-based semiconductor crystal 10 generally has a high-dislocation density region 11 formed on a buffer layer (not illustrated) provided immediately above the growth face of the first substrate 20 and a low-dislocation density region 12 grown on this high-dislocation density region 11. In the high-dislocation density region 11, there are extremely high-density dislocations reflecting the characteristic stepwise crystal growth (i.e., nuclear formation, selective growth, island growth, lateral growth and uniform growth) of the nitride-based semiconductor crystal. On the other hand, the low-dislocation density region 12 grown on the high-dislocation density region 11 is low-dislocated. Hence, the fabrication of a nitride-based semiconductor device is performed in the low-dislocation density region 12.

Hydrogen ions are implanted into the nitride-based semiconductor crystal 10 having such a dislocation distribution as described above to form a hydrogen ion-implanted layer 13 within the low-dislocation density region 12 (Figure 1(B)). In this figure, an average ion implantation depth is denoted by "L". For the hydrogen ion implantation, the dose amount is specified as approximately 10¹⁶ to 10¹⁷ atoms/cm² and the average ion implantation depth L is set to a value almost the same as the thickness of a nitride-based semiconductor layer to be subsequently obtained. Under normal conditions, however, the average ion implantation depth L is defined as L = 0.05 to 0.3 µm.

Then, the nitride-based semiconductor crystal 10 and the second substrate 30 are bonded together (Figure 1(C)). In this state, impact is applied externally to separate the low-dislocation density region 12 of the nitride-based semiconductor crystal 10 along the hydrogen ion-implanted layer 13, thereby transferring (peeling off) the surface layer part 12b of the low-dislocation density region 12 onto the second substrate 30. Note here that the lower layer part 12a of the low-dislocation density region 12 stays on the first substrate 20 without being transferred onto the second substrate 30 (Figure 1(D)).

One of reasons for forming the hydrogen ion-implanted layer 13 within the low-dislocation density region 12 is because the surface of the nitride-based semiconductor crystal transferred onto the second substrate 30 after separation will have high-density dislocations if the hydrogen ion-implanted layer 13 is formed within the high-dislocation density region 11. Accordingly, if elements are formed within a layer of such a nitride-based semiconductor crystal, it is not possible to obtain satisfactory element characteristics since the carrier mobility and the like of the elements are low.

The second substrate 30 onto which the surface layer part 12b of the low-dislocation density region 12 has been transferred is defined as a semiconductor substrate available by the manufacturing method of the present invention. The first substrate 20 on which the lower layer part 12a of the low-dislocation density region 12 stays is used once again as a substrate for epitaxial growth.

As already described, the surface of the nitride-based semiconductor crystal staying on the first substrate 20 has a low dislocation density since the hydrogen ion-implanted layer 13 is formed within the low-dislocation density region 12. Consequently, it is easy to obtain a film having excellent crystal quality in a case where a nitride-based semiconductor crystal is epitaxially grown again on this crystal surface. The nitride-based semiconductor crystal can be once again used for the above-described process to repeat the reuse thereof. Since such reuse eliminates the need for a new sapphire substrate or SiC substrate as the first substrate for the growth of the nitride-based semiconductor crystal, it is possible to provide a semiconductor substrate whereby a nitride-based semiconductor device can be manufactured at low costs.

Note here that a variety of substrates can be selected as the second substrate 30 onto which the surface layer part 12b of the low-dislocation density region 12 is transferred. A selection is made in consideration of heat radiation characteristics, translucency, mechanical strength as a substrate, or the like required when elements are formed on this surface layer part 12b. As such a second substrate 30 as described above, there are exemplified a silicon substrate, a silicon substrate on the bonding surface of which an oxide film has been previously formed, an SOI substrate, a compound semiconductor substrate, such as a gallium phosphide (GaP) substrate, a metal substrate, and a glass substrate, such as a quartz substrate. Note that embedded type elements may as well be formed previously on the bonding surface side of the second substrate 30.

Hence, as the second substrate 30, it is possible to select a sapphire substrate, a silicon carbide (SiC) substrate, a zinc oxide (ZnO) substrate or the like made of a material identical to that of the first substrate 20. However, since single-crystal substrates made of these materials are costly, it is preferable to use a sintered compact substrate the bonding surface of which has been mirror-polished, a polycrystalline substrate or an amorphous substrate, in order to achieve cost reductions.

Hereinafter, a process example of a method for manufacturing a semiconductor substrate according to the present invention will be described with reference to embodiments thereof.

### Embodiments

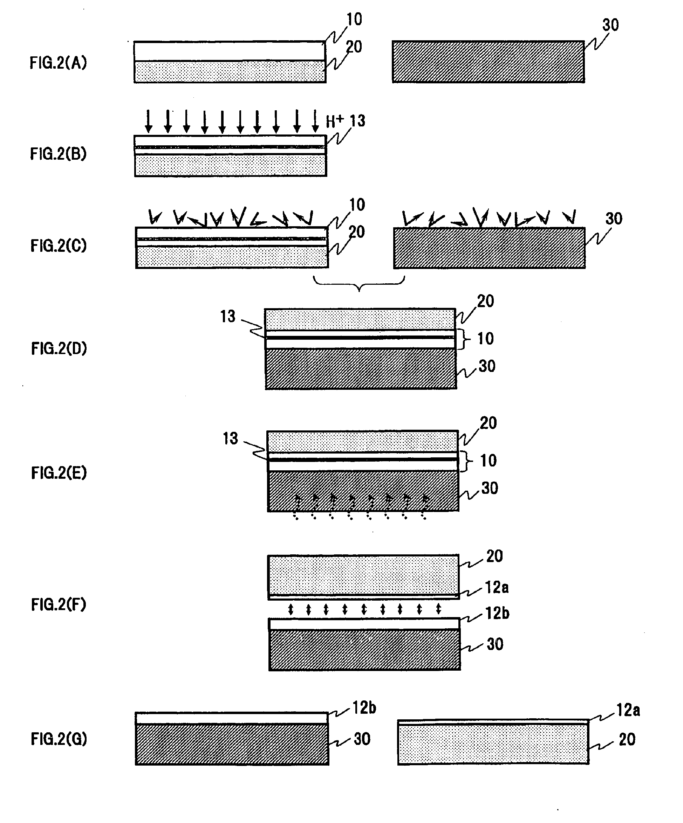

Figure 2 is a schematic view used to explain a process example of a method for manufacturing a semiconductor substrate of the present invention. As illustrated in Figure 2(A), there are prepared a substrate having a film of a nitride-based semiconductor crystal 10 epitaxially grown on a first substrate 20 using an MOVPE method, and a second substrate 30 to be bonded to the substrate. Note here that the first substrate 20 is a sapphire substrate and the second substrate 30 is a silicon substrate. In addition, the nitride-based semiconductor crystal 10 is an approximately 3 µm-thick nitride-based semiconductor film formed of GaN.

First, hydrogen ions are implanted into a surface of the nitride-based semiconductor crystal 10 to form a hydrogen ion-implanted layer 13 within the low-dislocation density region of this film (Figure 2(B)). Since an approximately 0.5 µm-thick region on the first substrate 20 side of the nitride-based semiconductor crystal 10 is a high-dislocation density region, hydrogen ions are implanted at a dose amount of 1 × 10¹⁷ atoms/cm² with the average ion implantation depth L set to approximately 2 µm, so that the hydrogen ion-implanted layer 13 is not formed in the high-dislocation density region.

Next, a plasma treatment or an ozone treatment for the purpose of surface cleaning, surface activation and the like is applied to the surface (bonding surface) of the nitride-based semiconductor crystal 10 after hydrogen ion implantation and to the bonding surface of the second substrate 30 (Figure 2(C)). Note that such a surface treatment as described above is performed for the purpose of removing organic matter from a surface serving as a bonding surface or achieving surface activation by increasing surface OH groups. However, the surface treatment need not necessarily be applied to both of the bonding surfaces of the nitride-based semiconductor crystal 10 and the second substrate 30. Rather, the surface treatment may be applied to either one of the two bonding surfaces.

When carrying out this surface treatment by means of plasma treatment, a substrate to which RCA cleaning or the like has been applied previously is mounted on a sample stage within a vacuum chamber, and a gas for plasma is introduced into the vacuum chamber so that a predetermined degree of vacuum is reached. Note that examples of gas species for plasma used here include an oxygen gas, a hydrogen gas, an argon gas, a mixed gas thereof, or a mixed gas of hydrogen and helium, and the gas species may be changed as necessary depending on the surface condition of the substrate or the purpose of use thereof. High-frequency plasma having an electrical power of approximately 100 W is generated after the introduction of the gas for plasma, thereby applying the surface treatment for approximately 5 to 10 seconds to a surface of the substrate to be plasma-treated, and then finishing the surface treatment.

When the surface treatment is carried out by means of ozone treatment, a surface-cleaned substrate to which RCA cleaning or the like has been applied is mounted on a sample stage within a chamber placed in an oxygen-containing atmosphere. Then, after introducing a gas for plasma, such as a nitrogen gas or an argon gas, into the chamber, high-frequency plasma having a predetermined electrical power is generated to convert oxygen in the atmosphere into ozone by the plasma. Thus, a surface treatment is applied for a predetermined length of time to a surface of the substrate to be treated.

After such a surface treatment as described above, the nitride-based semiconductor crystal 10 and the second substrate 30 are bonded together by closely adhering the surfaces thereof to each other as bonding surfaces (Figure 2(D)). As described above, the surface (bonding surface) of at least one of the nitride-based semiconductor crystal 10 and the second substrate 30 has been subjected to a surface treatment by plasma treatment, ozone treatment or the like and is therefore activated. Thus, it is possible to obtain a level of bonding strength fully resistant to mechanical separation or mechanical polishing in a post-process even if the substrates are closely adhered to each other (bonded together) at room temperature. If the substrates need to have an even higher level of bonding strength, there may be provided a sub-step of applying a "bonding process" by heating the substrates at a relatively low temperature in succession to the "bonding together" illustrated in Figure 2(D).

The bonding process temperature at this time is selected as appropriate according to the types and the like of the first and second substrates to be used for bonding. If the thermal expansion coefficients of the two substrates significantly differ from each other or if elements are previously formed in at least one of the substrates, the temperature is set to 450°C or lower, for example, within a range from 200 to 450°C, so that the bonding process does not cause any variation in element characteristics.

In succession to such a treatment as described above, a nitride-based semiconductor thin film is peeled off along the hydrogen ion-implanted layer 13 by applying external impact to the bonded substrate using a certain technique (Figure 2(F)), thereby obtaining a nitride-based semiconductor layer (surface layer part 12b of a low-dislocation density region) on the second substrate 30 (Figure 2(G)). Note that since the first substrate 20 is in a state on which the lower layer part 12a of the low-dislocation density region stays, the first substrate 20 is used once again as a substrate for epitaxial growth.

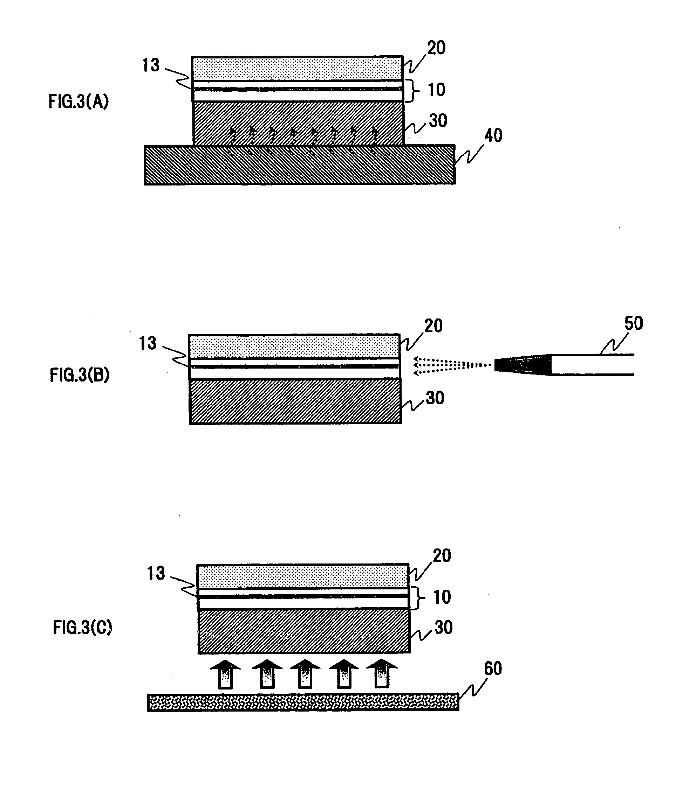

Note here that there can be various ways of externally applying impact in order to peel off a nitride-based semiconductor thin film. Figure 3 is a conceptual schematic view used to explain various techniques for peeling off a nitride-based semiconductor thin film, wherein Figure 3(A) illustrates an example of performing separation by thermal shock, Figure 3(B) illustrates an example of performing separation by mechanical shock, and Figure 3(C) illustrates an example of performing separation by vibratory shock.

In Figure 3(A), reference numeral 40 denotes a heating section, such as a hot plate, having a smooth surface, and the bonded substrate is mounted on the smooth surface of the heating section 40 kept at, for example, approximately 300°C. In Figure 3(A), a silicon substrate, which is the second substrate 30, is mounted so as to closely adhere to the heating section 40. The silicon substrate, which is the second substrate 30, is heated by thermal conduction and a stress is generated between the silicon substrate and a sapphire substrate, which is the first substrate 20, by a temperature difference produced between the two substrates. The separation of the nitride-based semiconductor thin film along the hydrogen ion-implanted layer 13 is caused by this stress.

The example illustrated in Figure 3(B) utilizes a jet of a fluid to apply mechanical shock. That is, a fluid, such as a gas or a liquid, is sprayed in a jet-like manner from the leading end of a nozzle 50 at a side surface of the nitride-based semiconductor crystal 10, thereby applying impact. An alternative technique, for example, is to apply impact by pressing the leading end of a blade against a region near the hydrogen ion-implanted layer 13.

Yet alternatively, as illustrated in Figure 3(C), the separation of the nitride-based semiconductor thin film may be caused by applying vibratory shock using ultrasonic waves emitted from the vibrating plate 60 of an ultrasonic oscillator.

As described above, in the present invention, the hydrogen ion-implanted layer is formed in the nitride-based semiconductor crystal provided on the first substrate, and this nitride-based semiconductor crystal and the second substrate are bonded together to transfer the surface layer part of the low-dislocation density region of the nitride-based semiconductor crystal onto the second substrate. Consequently, there is no need to use any costly substrates for the growth of a nitride-based semiconductor crystal.

In addition, since the first substrate in a state on which the lower layer part of the low-dislocation density region of the nitride-based semiconductor crystal stays can be used once again as a substrate for epitaxial growth, it is possible to provide a semiconductor substrate whereby a nitride-based semiconductor device can be manufactured at low costs.

Furthermore, a method for manufacturing a semiconductor substrate according to the present invention does not involve applying a heat treatment at high temperatures, thereby preventing cracks or the like from occurring in a substrate, and thereby avoiding causing the characteristics of elements to vary even if a substrate in which the elements have already been formed is bonded.

### Industrial Applicability

The present invention provides a method for manufacturing a semiconductor substrate whereby a nitride-based semiconductor device can be provided at low costs. In addition, according to the present invention, there is provided a method for manufacturing a semiconductor substrate based on a low-temperature process, thereby avoiding causing the characteristics of elements to vary even if a substrate in which the elements have already been formed is bonded.

## Claims

1. A method for manufacturing a semiconductor substrate, comprising:
a first step of forming a hydrogen ion-implanted layer (13) on a surface side of a nitride-based semiconductor crystal (10) epitaxially grown on a first substrate (20);
a second step of applying a surface activation treatment to at least one of a surface of a second substrate (30) and the surface of said nitride-based semiconductor crystal (10);
a third step of bonding together the surface of said nitride-based semiconductor crystal (10) and the surface of said second substrate (30); and
a fourth step of forming a nitride-based semiconductor layer on said second substrate (30) by peeling off a nitride-based semiconductor crystal (10) along said hydrogen ion-implanting layer (13), wherein said nitride-based semiconductor crystal (10) is one of a GaN-based crystal, an AlN-based crystal and an InN-based crystal, and said hydrogen ion-implanted layer (13) is formed in the low-dislocation density region (12) of said nitride-based semiconductor crystal (10).

2. The method for manufacturing a semiconductor substrate according to claim 1, wherein said second step of surface activation treatment is carried out by means of at least one of plasma treatment and ozone treatment.

3. The method for manufacturing a semiconductor substrate according to claim 1 or 2, wherein said third step includes a sub-step of heat-treating said nitride-based semiconductor crystal (10) and said second substrate(30) after said bonding together, with said nitride-based semiconductor crystal (10) and said second substrate (30) bonded together.

4. The method for manufacturing a semiconductor substrate according to claim 3, wherein said sub-step of heat treatment is carried out at a temperature of 200°C or higher but not higher than 450°C.

5. The method for manufacturing a semiconductor substrate according to any one of claims 1 to 4, wherein said fourth step is carried out by applying mechanical shock from an edge of said hydrogen ion-implanted layer (13).

6. The method for manufacturing a semiconductor substrate according to any one of claims 1 to 4, wherein said fourth step is carried out by applying vibratory shock to said bonded substrate.

7. The method for manufacturing a semiconductor substrate according to any one of claims 1 to 4, wherein said fourth step is carried out by applying thermal shock to said bonded substrate.

8. The method for manufacturing a semiconductor substrate according to any one of claims 1 to 7, further including a fifth step of epitaxially growing a nitride-based semiconductor crystal (10) on a nitride-based semiconductor layer staying on said first substrate(20) after said peel-off, thereby providing a new substrate for bonding, wherein said first to fourth steps are repeated.

## Patentansprüche

1. Verfahren zur Herstellung eines Halbleitersubstrats, umfassend:
einen ersten Schritt zum Bilden einer Wasserstoffionen-implantierten Schicht (13) auf einer Oberflächenseite eines Nitrid-basierten Halbleiterkristalls (10), der epitaxial auf einem ersten Substrat (20) gewachsen ist;
einem zweiten Schritt zum Anwenden einer Oberflächenaktivierungsbehandlung auf mindestens eine von einer Oberfläche eines zweiten Substrats (30) und der Oberfläche des Nitrid-basierten Halbleiterkristalls (10) ;
einen dritten Schritt zum Verbinden der Oberfläche des Nitrid-basierten Halbleiterkristalls (10) und der Oberfläche des zweiten Substrats (30); und
einen vierten Schritt zum Bilden einer Nitrid-basierten Halbleiterschicht auf dem zweiten Substrat (30) durch Ablösen eines Nitrid-basierten Halbleiterkristalls (10) entlang der Wasserstoffionen-implantierten Schicht (13), worin der Nitrid-basierte Halbleiterkristall (10) einer von einem GaN-basierten Kristall, einem AlN-basierten Kristall und einem InN-basierten Kristall ist und die Wasserstoffionen-implantierte Schicht (13) in einem Bereich mit niedriger Dislokationsdichte (12) des Nitrid-basierten Halbleiterkristalls (10) gebildet ist.

2. Verfahren zur Herstellung eines Halbleitersubstrats gemäß Anspruch 1, worin der zweite Schritt der Oberflächenaktivierungsbehandlung durchgeführt wird durch mindestens eines von Plasmabehandlung und Ozonbehandlung.

3. Verfahren zur Herstellung eines Halbleitersubstrats gemäß Anspruch 1 oder 2, worin der dritte Schritt einen Unterschritt zur Wärmebehandlung des Nitrid-basierten Halbleiterkristalls (10) und des zweiten Substrats (30) nach dem Verbinden umfasst, wobei der Nitrid-basierte Halbleiterkristall (10) und das zweite Substrat (30) miteinander verbunden sind.

4. Verfahren zur Herstellung eines Halbleitersubstrats gemäß Anspruch 3, worin der Unterschritt zur Wärmebehandlung durchgeführt wird bei einer Temperatur von 200°C oder höher, jedoch nicht höher als 450°C.

5. Verfahren zur Herstellung eines Halbleitersubstrats gemäß irgendeinem der Ansprüche 1 bis 4, worin der vierte Schritt durchgeführt wird durch Ausüben eines mechanischen Schocks von einer Kante der Wasserstoffionen-implantierten Schicht (13).

6. Verfahren zur Herstellung eines Halbleitersubstrats gemäß irgendeinem der Ansprüche 1 bis 4, worin der vierte Schritt durchgeführt wird durch Anwenden eines Vibrationsschocks auf das gebundene Substrat.

7. Verfahren zur Herstellung eines Halbleitersubstrats gemäß irgendeinem der Ansprüche 1 bis 4, worin der vierte Schritt durchgeführt wird durch Anwenden eines thermischen Schocks auf das gebundene Substrat.

8. Verfahren zur Herstellung eines Halbleitersubstrats gemäß irgendeinem der Ansprüche 1 bis 7, ferner umfassend einen fünften Schritt zum epitaxialen Wachsenlassen eines Nitrid-basierten Halbleiterkristalls (10) auf einer Nitrid-basierten Halbleiterschicht, die nach dem Ablösen auf dem ersten Substrat (20) verbleibt, wodurch ein neues Substrat zum Verbinden bereitgestellt wird, worin die ersten bis vierten Schritte wiederholt werden.

## Revendications

1. Procédé destiné à fabriquer un substrat semi-conducteur, comprenant :
une première étape consistant à former une couche implantée d'ions hydrogène (13) sur un côté de surface d'un cristal semi-conducteur à base de nitrure (10) formé par croissance épitaxiale sur un premier substrat (20) ;
une deuxième étape consistant à appliquer un traitement d'activation de surface à au moins l'une parmi une surface d'un deuxième substrat (30) et la surface dudit cristal semi-conducteur à base de nitrure (10) ;
une troisième étape consistant à lier ensemble la surface dudit cristal semi-conducteur à base de nitrure (10) et la surface dudit deuxième substrat (30) ; et
une quatrième étape consistant à former une couche de semi-conducteur à base de nitrure sur ledit deuxième substrat (30), en décollant un cristal semi-conducteur à base de nitrure (10) le long de ladite couche implantée d'ions hydrogène (13), où ledit cristal semi-conducteur à base de nitrure (10) est l'un parmi un cristal à base de GaN, un cristal à base d'ALN et un cristal à base d'InN, et ladite couche implantée d'ions hydrogène (13) est formée dans la zone à faible densité de dislocations (12) dudit cristal semi-conducteur à base de nitrure (10).

2. Procédé destiné à fabriquer un substrat semi-conducteur selon la revendication 1, dans lequel ladite deuxième étape d'un traitement d'activation de surface est effectuée au moyen d'au moins l'un d'un traitement au plasma et d'un traitement à l'ozone.

3. Procédé destiné à fabriquer un substrat semi-conducteur selon la revendication 1 ou 2, dans lequel ladite troisième étape comporte une sous-étape de traitement thermique dudit cristal semi-conducteur à base de nitrure (10) et dudit deuxième substrat (30) après leur dite liaison ensemble, avec ledit cristal semi-conducteur à base de nitrure (10) et ledit deuxième substrat (30) liés ensemble.

4. Procédé destiné à fabriquer un substrat semi-conducteur selon la revendication 3, dans lequel ladite sous-étape de traitement thermique est effectuée à une température supérieure ou égale à 200°C mais ne dépassant pas 450°C.

5. Procédé destiné à fabriquer un substrat semi-conducteur selon l'une quelconque des revendications 1 à 4, dans lequel ladite quatrième étape est effectuée en appliquant un choc mécanique à partir d'un bord de ladite couche implantée d'ions hydrogène (13).

6. Procédé destiné à fabriquer un substrat semi-conducteur selon l'une quelconque des revendications 1 à 4, dans lequel ladite quatrième étape est effectuée en appliquant un choc vibratoire audit substrat lié.

7. Procédé destiné à fabriquer un substrat semi-conducteur selon l'une quelconque des revendications 1 à 4, dans lequel ladite quatrième étape est effectuée en appliquant un choc thermique audit substrat lié.

8. Procédé destiné à fabriquer un substrat semi-conducteur selon l'une quelconque des revendications 1 à 7, comportant en outre une cinquième étape consistant à former par croissance épitaxiale un cristal semi-conducteur à base de nitrure (10) sur une couche de semi-conducteur à base de nitrure restant sur ledit premier substrat (20) après ladite étape de décollement, fournissant ainsi un nouveau substrat pour la liaison, où lesdites première à quatrième étapes sont répétées.
